Europäisches Patentamt

European Patent Office

Office européen des brevets

Numéro de publication: **0 274 940**
**A1**

## DEMANDE DE BREVET EUROPEEN

(21) Numéro de dépôt: 87402815.2

(22) Date de dépôt: 11.12.87

(51) Int. Cl.⁴ **H01L 31/10** , H01L 31/02 , H01J 1/34

(30) Priorité: 12.12.86 FR 8617406

(43) Date de publication de la demande:
20.07.88 Bulletin 88/29

(84) Etats contractants désignés:
DE GB NL

(71) Demandeur: THOMSON-CSF
173, Boulevard Haussmann
F-75379 Paris Cédex 08(FR)

(72) Inventeur: Tardella, Armand
THOMSON-CSF SCPI 19, avenue de Messine
F-75008 Paris(FR)
Inventeur: Weil, Thierry
THOMSON-CSF SCPI 19, avenue de Messine
F-75008 Paris(FR)
Inventeur: Vinter, Borge
THOMSON-CSF SCPI 19, avenue de Messine
F-75008 Paris(FR)

(74) Mandataire: Turlèque, Clotilde et al
THOMSON-CSF SCPI 19, avenue de Messine
F-75008 Paris(FR)

(54) Dispositif de multiplication de porteurs de charge par un phénomène d'avalanche, et son application aux photodétecteurs, aux photocathodes, et aux visionneurs infrarouges.

㉗ Dispositif de multiplication de porteurs de charge (DMPC) d'un type donné par un phénomène d'avalanche qui comporte :
- placé dans un champ électrique ( $\vec{E}_f$), un matériau semiconducteur (1) de composition homogène ;
- réalisées dans ce matériau (1), perpendiculairement au champ de fonctionnement ( $\vec{E}_f$), des couches (2-i) planes et parallèles, fines par rapport à l'épaisseur du matériau les séparant, dopées n ou p suivant ledit type de porteurs de charge, ces couches constituant des réservoirs où sont confinés des porteurs de charge dudit type.

L'injection d'au moins un porteur de charge (3) dudit type dans le DMPC déclenche le phénomène de multiplication par un processus de collision ionisante ; ce porteur de charge (3) est accéléré par le champ de fonctionnement ( $\vec{E}_f$) et acquiert ainsi une énergie suffisante pour être susceptible d'éjecter un porteur de charge (4-2) dudit type de la couche dopée (2-1) ; les porteurs de charge (4-1) et (4-2) obtenus sont guidés par le champ de fonctionnement ( $\vec{E}_f$), ce mécanisme de collisions ionisantes se reproduit de proche en proche dans les couches dopées (2-i) et constitue ainsi un phénomène de multiplication par avalanche.

Application de ce dispositif aux photodétecteurs, aux photocathodes, et aux visionneurs infrarouges.

FIG_1a

# DISPOSITIF DE MULTIPLICATION DE PORTEURS DE CHARGE PAR UN PHENOMENE D'AVALANCHE ET SON APPLICATION AUX PHOTODETECTEURS, AUX PHOTOCATHODES, ET AUX VISIONNEURS INFRA--ROUGES

La présente invention a pour objet un dispositif de multiplication de porteurs de charge d'un type donné (électrons ou trous) à faible bruit, la multiplication se produisant par un processus de collisions ionisantes, un porteur de charge d'un type donné, pouvant ainsi libérer par collision un ou plusieurs autres porteurs de charge du même type, susceptibles à leur tour de libérer des porteurs de charge dudit type supplémentaires, ceci constituant un phénomène d'avalanche.

Dans un dispositif de multiplication de porteurs de charge par avalanche, constitué d'un semiconducteur, le bruit dépend du rapport des coefficients d'ionisation des deux types de porteurs de charge (électrons et trous) présents dans ce dispositif semiconducteur, et du mécanisme qui déclenche la multiplication par avalanche, le coefficient d'ionisation d'un porteur de charge étant la probabilité par unité de longueur pour que ce porteur de charge subisse une collision ionisante. Le bruit du dispositif à avalanche est faible si les porteurs de charge que l'on désire multiplier ont un coefficient d'ionisation très supérieur aux porteurs de charge opposée. Une seconde source de bruit d'un tel dispositif est reliée à la dispersion du nombre de collisions ionisantes par porteur de charge initial. Ce bruit "statistique" du dispositif est diminué si la multiplication desdits porteurs de charge dans le semiconducteur n'a pas lieu de manière uniforme, mais se produit au contraire à certains endroits précis du matériau.

Pour obtenir un bon rapport signal sur bruit dans un dispositif de multiplication de porteurs de charge par avalanche, il est donc nécessaire de minimiser les deux types de bruit décrits dans les deux paragraphes précédents.

Il existe un tel dispositif dans l'art antérieur, décrit par F. Capasso et al. dans l'article de la page 1294 de la revue Appl. Phys. Lett. 48 (19) du 12 mai 1986. Ce dispositif comporte un matériau non conducteur d'électricité, formé d'une suite d'hétérojonctions sensiblement parallèles entre des semiconducteurs de natures différentes (on entend par le terme "hétérojonction", une jonction entre deux matériaux différents ou de compositions différentes). Ces hétérojonctions introduisent dans la structure de bandes du matériau, selon une direction sensiblement perpendiculaire auxdites hétérojonctions, des discontinuités formant des puits de potentiel carrés, qui constituent des réservoirs où sont confinés des porteurs de charge d'un type donné. Ce matériau est placé dans un champ électrique, dit champ de fonctionnement, qui est appliqué selon une direction sensiblement perpendiculaire auxdites hétérojonctions. La multiplication des porteurs de charges dudit type est déclenchée par l'injection d'au moins un porteur de charge du même type, celui-ci est accéléré par le champ de fonctionnement, et acquiert ainsi une énergie suffisante pour être susceptible d'éjecter par un processus de collision ionisante un porteur de charge dudit type hors du puit de potentiel où il est confiné. Les porteurs de charge dudit type sont guidés par le champ de fonctionnement. Ce mécanisme d'éjection se reproduit de proche en proche et constitue un processus de multiplication par avalanche. Malheureusement, la croissance cristalline de telles hétérostructures est extrêmement délicate : d'une part elle nécessite le contrôle précis d'un grand nombre de paramètres, et d'autre part la réalisation d'interfaces "propres", c'est-à-dire bien définies du point de vue cristallographique, est difficile.

De plus, les puits de potentiel obtenus dans la structure de bande d'un tel matériau sont peu profonds ; la probabilité pour qu'un porteur de charge possède une énergie thermique suffisante pour sortir spontanément du puits de potentiel où il est confiné est donc élevée. Par conséquent, ce dispositif possède un fort bruit thermique.

L'objet de la présente invention est un dispositif de multiplication de porteurs de charge, noté DMPC par la suite, basé sur le même principe de fonctionnement que le dispositif décrit au paragraphe précédent et faisant partie de l'art antérieur, mais comportant un matériau non conducteur d'électricité constitué d'un semiconducteur unique de composition homogène au sein duquel sont réalisées des couches sensiblement parallèles dopées n ou p suivant le type de porteurs de charge que l'on désire multiplier. En effet, le DMPC objet de la présente invention peut multiplier :
- soit des électrons, il constitue alors un dispositif de multiplication d'électrons noté DME par la suite ;
- soit des trous, il constitue alors un dispositif de multiplication de trous, noté DMT par la suite : ces couches sont séparées par des portions dudit matériau non conducteur d'électricité, et les épaisseurs desdites couches sont très inférieures aux dimensions, selon une direction sensiblement perpendiculaire auxdites couches, desdites portions.

La croissance cristalline d'un tel semiconducteur unique de composition homogène contenant des couches dopées sensiblement parallèles est beaucoup moins difficile à réaliser que celle d'une hétérostructure comme celle faisant partie de l'art antérieur. en effet le nombre de paramètres à contrôler au cours de la croissance cristalline est plus faible.

En conséquence, un tel semiconducteur unique contenant des couches dopées est beaucoup plus facile à industrialiser qu'une hétérostructure telle que décrite précédemment.

En outre, le dopage d'un tel semiconducteur unique permet d'obtenir des puits de potentiel bien plus profonds que les puits de potentiel carrés dus aux hétérojonctions de l'hétérostructure décrite ci-dessus. Le DMPC, objet la présente invention, possède un bruit thermique beaucoup plus faible que le dispositif appartenant à l'art antérieur.

L'invention a plus précisément pour objet un dispositif de multiplication de porteurs de charge d'un type donné par un phénomène d'avalanche tel que défini par la revendi-cation 1.

Des perfectionnements, modes de réalisation, ainsi que d'autres avantages et particularités de l'invention apparaîtront au cours de la description qui suit, à l'aide des figures qui représentent :

- la figure 1a, illustrant le principe de l'invention dans le cas d'une multiplication d'électrons ;

- la figure 1b, illustrant le principe de l'invention dans le cas d'une multiplication de trous ;

- la figure 2a, représentant la structure de bande d'un matériau semiconducteur ;

- la figure 2b, représentant la structure de bande du matériau semiconducteur formant un DME selon l'invention, lorsque ce matériau n'est pas placé dans un champ électrique ;

- la figure 2c, représentant la structure de bande du matériau semiconducteur formant un DMT selon l'invention, lorsque ce matériau n'est pas placé dans un champ électrique ;

- la figure 3a, représentant des puits de potentiel introduits dans la structure de bandes d'un matériau semiconducteur par la réalisation de couches dopées n monoatomiques ;

- la figure 3b représentant des puits de potentiel analogues à ceux de la figure 3a dans le cas où les couches dopées n comportent plusieurs plans cristallins ;

- la figure 4a, représentant la structure de bande du matériau semiconducteur formant un DME selon l'invention, lorsque ce matériau est placé dans un champ électrique dit champ de fonctionnement et illustrant le fonctionnement de ce DME ;

- la figure 4b, représentant la structure de bande du matériau semiconducteur formant un DMT selon l'invention, lorsque ce matériau est placé dans un champ électrique dit de fonctionnement, et illustrant le fonctionnement de ce DMT ;

- la figure 5a. illustrant l'application d'un DME selon l'invention aux photodétecteurs :

- la figure 5b illustrant l'application d'un DMT selon l'invention aux photodétecteurs ;

- la figure 6. illustrant l'application d'un DME selon l'invention aux photocathodes ;

- la figure 7a, illustrant l'application d'un DME selon l'invention aux visionneurs infrarouges ;

- la figure 7b, illustrant l'application d'un DMT selon l'invention aux visionneurs infrarouges.

Sur ces différentes figures, d'une part l'échelle réelle n'a pas été respectée, et d'autre part les mêmes références se rapportent aux mêmes éléments.

L'objet de la présente invention est un dispositif de multiplication de porteurs de charge (DMPC) destiné à multiplier :
- soit des électrons, le dispositif constitue alors un DME ;
- soit des trous, le dispositif constitue alors un DMT.

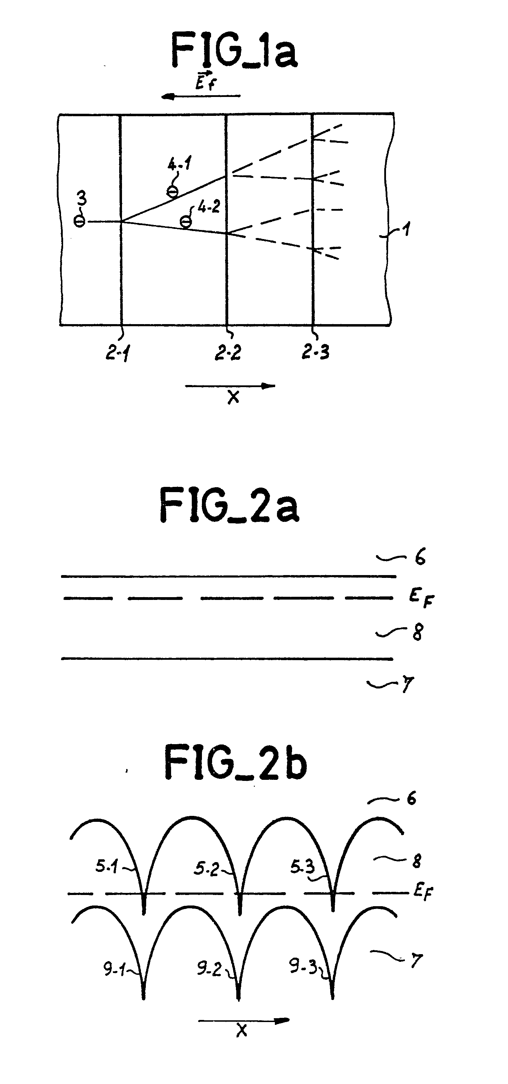

La figure 1a illustre le processus de multiplication d'électrons d'un DME. Cette figure 1a est une coupe représentant :
- le matériau semiconducteur 1, de préférence dopé p en volume ;
- réalisées dans le matériau 1, des couches 2-1 à 2-3 sensiblement parallèles dopées n, de préférence fortement et constituant des réservoirs d'électrons ;
- un champ électrique $\vec{E}_f$, dit de fonctionnement, appliqué selon une direction X sensiblement perpendiculaire aux couches dopées n au moyen d'électrodes placées à chaque extrémité du matériau ;
cette coupe illustrant le mécanisme de multiplication d'électrons du DME :
- l'injection d'un électron 3 dans cette structure déclenche le processus de multiplication d'électrons ; cet électron 3 est accéléré par le champ électrique de fonctionnement $\vec{E}_f$ et acqui-ert ainsi une énergie suffisante pour être susceptible de libérer par impact un électron 4-2 de la couche 2-1 ; les électrons 4-1 et 4-2 obtenus sont guidés et à leur tour accélérés par le champ de fonctionnement $\vec{E}_f$, ils sont eux aussi susceptibles de libérer par impact d'autres électrons de la couche 2-2 ; ce mécanisme se reproduit de proche en proche et constitue le processus de multiplication d'électrons par avalanche.

La figure 1b illustre de manière analogue le processus de multiplication de trous d'un DMT. Cette figure 1b est une coupe représentant :
- le matériau semiconducteur 1, de préférence dopé n en volume ;
- réalisées dans le matériau 1, des couches 2-1 à 2-3 sensiblement parallèles dopées p, de préférence fortement, et constituant des réservoirs de trous ;

- un champ électrique $\vec{E}_f$, dit de fonctionnement, appliqué de la même façon que celui du DME, mais de sens opposé ;

cette coupe illustrant le mécanisme de multiplication de trous du DMT qui est l'analogue de celui du DME, les trous remplaçant les électrons.

Un parallélisme rigoureux des couches 2-1 à 2-3 dopées, n dans le cas d'un DME, et p dans le cas d'un DMT, n'est pas indispensable au fonctionnement du DMPC ; cependant la croissance cristalline du matériau 1 se fait couche par couche : de ce fait, les couches dopées réalisées dans le matériau sont de fait sensiblement parallèles.

La figure 2a représente une partie de la structure de bande d'un matériau semiconducteur, dans une direction donnée ; la bande de valence 7 et la bande de conduction 6 sont séparées par une bande interdite 8, où se trouve le niveau de Fermi $E_F$.

La figure 2b représente une partie de la structure de bande dans la direction X du matériau semiconducteur 1 formant un DME lorsque ce matériau n'est pas placé dans le champ de fonctionnement $\vec{E}_f$. La réalisation des couches dopées n 2-1 à 2-3 introduit des puits de potentiel 9-1 à 9-3 dans la bande de valence 7 et 5-1 à 5-3 dans la bande de conduction 6, l'épaisseur des couches 2-1 à 2-3 étant telle que l'énergie du fond desdits puits 5-1 à 5-3 soit inférieure au niveau de Fermi $E_F$ du matériau, ces puits constituant ainsi des réservoirs où sont confinés des électrons.

La distance entre les couches 2-i dopées n réalisées dans le matériau est telle que deux puits de potentiel voisins soient suffisamment éloignés l'un de l'autre pour qu'un électron confiné au fond d'un puit 5-i de la bande de conduction 6 n'ait qu'une très faible chance de passer de ce puit à son voisin par effet tunnel.

Afin d'optimiser le DME, on réalise sensiblement la désertion en porteurs de charge libres des régions situées entre deux couches 2-i dopées n voisines. Pour ce :

- le semiconducteur 1 est dopé p en volume, les porteurs de charge libres situés dans lesdites régions sont alors principalement des trous ;

- la concentration volumique en impuretés de type accepteur notée $N_a$ et correspondant au dopage p en volume, la concentration surfacique en impuretés de type donneur notée $N_d$ et correspondant au dopage n des couches 2-i, et la distance entre deux couches 2-i dopées successives notée L, sont telles que l'on ait : .

$$N_d > N_a \times L$$

cette condition assure la disparition des trous dus au dopage p en volume du semiconducteur 1, grâce aux électrons contenus dans les couches 2-i dopées n, et ceci sans vider les réservoirs d'électrons constitués par les puits de potentiel 5-i et correspondant physiquement aux couches 2-i dopées n.

En outre, le dopage p du semiconducteur 1 rapproche le niveau de Fermi $E_F$ du sommet de la bande de valence 7 ; pour franchir la barrière de potentiel le séparant du continuum, un électron confiné au fond d'un puits 5-i de la bande de conduction 6, doit donc acquérir une énergie bien supérieure à son énergie thermique ; la probabilité pour qu'un tel électron sorte spontanément du puit où il est confiné est donc faible : autrement dit, le bruit thermique du DME est faible.

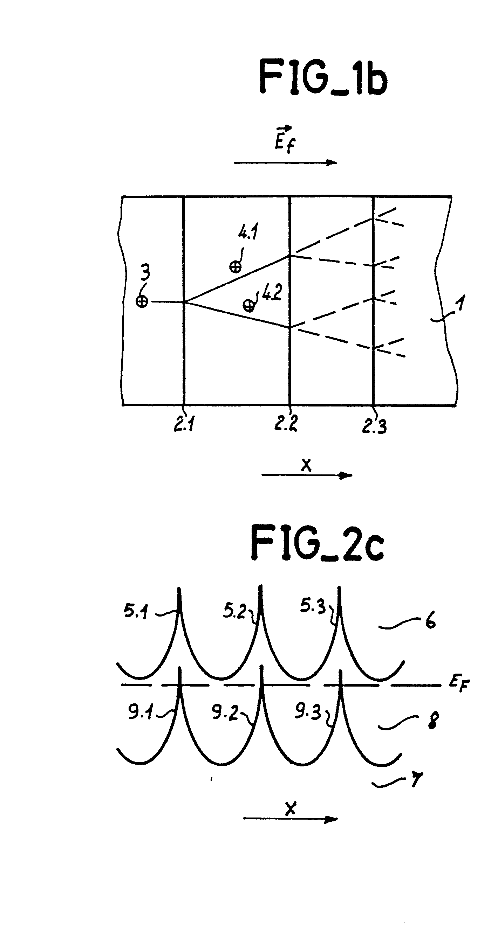

La figure 2c est l'analogue pour un DMT de la figure 2b s'appliquant au cas d'un DME. La description de la figure 2c se déduit donc de celle de la figure 2b en permutant respectivement les expressions :

- "DME" et "DMT" ;
- "dopé n" et "dopé p" ;
- "bande de valence" et "bande de conduction" ;
- "électrons" et "trous" ;
- "impuretés de type accepteur" et "impuretés de type donneur" ;
- "$N_d$" et "$N_a$", $N_d$ étant, pour un DMT, une concentration volumique et $N_a$ une concentration surfacique ;
- "sommet de la bande de valence 7" et "bas de la bande de conduction 6" ;
- "fond desdits puits 5-1 à 5-3" par "sommet desdits puits 9-1 à 9-3", et "inférieure au niveau de Fermi $E_F$" par "supérieure au niveau de Fermi $E_F$".

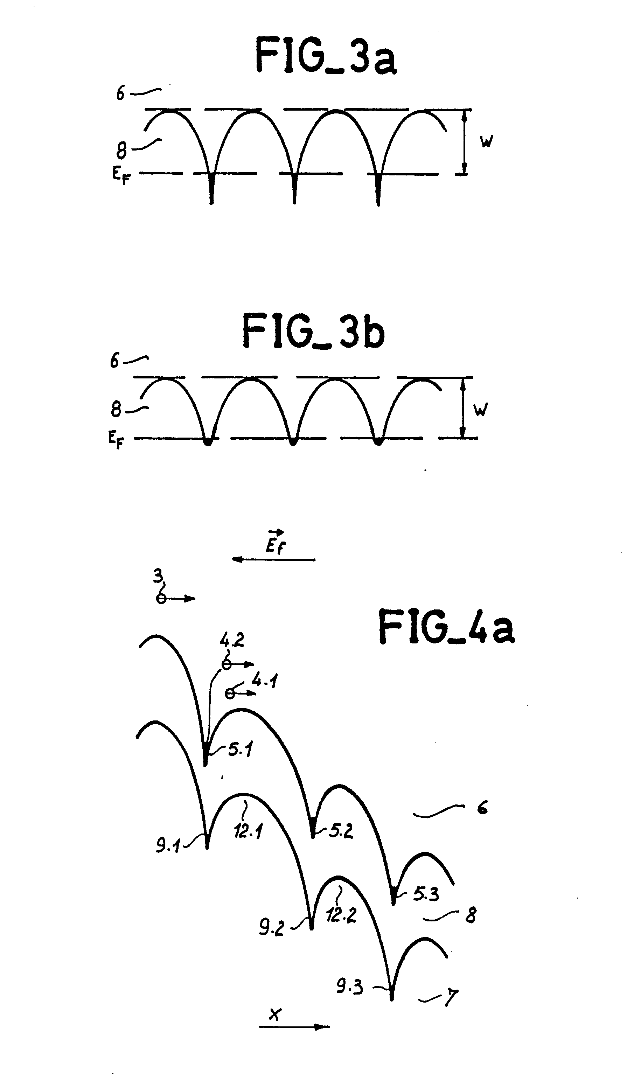

Sur les figures 3a et 3b sont schématisés des puits de potentiel introduits par la réalisation au sein du matériau constituant un DME de couches dopées n, par un même nombre d'impuretés de type donneur, dans deux cas différents :

- la figure 3a schématise des puits dus à un dopage plan, c'est-à-dire constitué de couches dopées monoatomiques ;

- la figure 3b schématise les mêmes puits lorsque les couches dopées comportent quelques (et non un seul) plans cristallins. Le remplissage des puits de potentiel, c'est-à-dire le nombre d'électrons stockés dans lesdits puits, est le même sur les deux figures (puisque le nombre d'impuretés de type donneur est le même dans les deux cas). Bien que la forme desdits puits soit différente dans les deux cas, l'énergie W (qui correspond à la différence d'énergie entre le niveau de Fermi et les bords du puits) que doit au moins acquérir un électron pour sortir du puits où il est confiné est presque la même dans ces deux cas. Le bruit thermique n'est donc presque pas modifié par le nombre de plans cristallins des couches dopées n. Il n'est donc pas nécessaire que lesdites couches dopées soient monoatomiques.

La description de figures analogues aux figures 3a et 3b, schématisant des puits de potentiel introduits par la réalisation au sein du matériau constituant un DMT. et non un DME. de couches dopées p. et non n. montrerait que lesdites couches n'ont pas non plus besoin d'être monoatomiques.

En pratique, une telle structure peut-être réalisée en $Al_{1-x} Ga_x As$ (o < x < 1) par épitaxie par jet moléculaire.

La réalisation d'une structure en matériaux semiconducteurs de plus grande bande interdite (GaP, AIP) permettrait d'obtenir des puits de potentiel plus profonds, et des énergies d'ionisation des porteurs de charge piégés dans les puits de potentiels plus élevées. et donc de diminuer encore le bruit thermique.

Le fonctionnement d'un DME est illustré par la figure 4a. Le matériau semiconducteur décrit dans ce qui précède est placé dans un champ électrique $\vec{E}_f$, dit de fonctionnement. La structure reste isolante ; ce caractère isolant est illustré par la figure 4a :

- les électrons confinés dans les puits 5-1 à 5-3 de la bande de conduction 6 ne peuvent pas conduire l'électricité, car la profondeur des puits est très supérieure à l'énergie thermique qu'ils peuvent acquérir et la distance entre deux puits voisins est suffisante pour que l'interaction par effet tunnel entre les puits de potentiel soit négligeable ;

- les trous situés aux sommets 12-1 et 12-2 de la bande de valence 7. ne peuvent pas conduire non plus car les puits de la bande de valence 7 constituent des barrières pour ces trous.

Par contre, si l'on injecte un électron libre 3 dans cette structure, celui-ci est accéléré par le champ électrique de fonctionnement $\vec{E}_f$, et acquiert ainsi une énergie suffisante pour être susceptible de libérer par impact un électron 4-2 confiné dans le puit suivant 5-1. Les électrons 4-1 et 4-2 obtenus sont guidés et à leur tour accélérés par le champ de fonctionnement $\vec{E}_f$, et sont susceptibles de libérer par impact d'autres électrons du puit 5-2. Ce mécanisme d'éjection d'électrons hors des puits de potentiel 5-i par des collisions ionisantes se reproduit de proche en proche, et constitue le phénomène de multiplication par avalanche, illustré par la figure 4a.

Le remplacement des électrons éjectés hors des puits de potentiel par des collisions ionisantes peut être effectué de plusieurs façons :

- soit par génération d'électrons à partir de la bande de valence ;

- soit en mettant en contact latéralement chacune des couches dopées 2-i avec un dispositif susceptible de fournir des électrons ;

- soit en imposant de manière périodique et pendant un faible intervalle de temps, un champ électrique de sens opposé à celui du champ électrique de fonctionnement $\vec{E}_f$ ; pendant ce

faible intervalle de temps. le DME est bien sûr non fonctionnel.

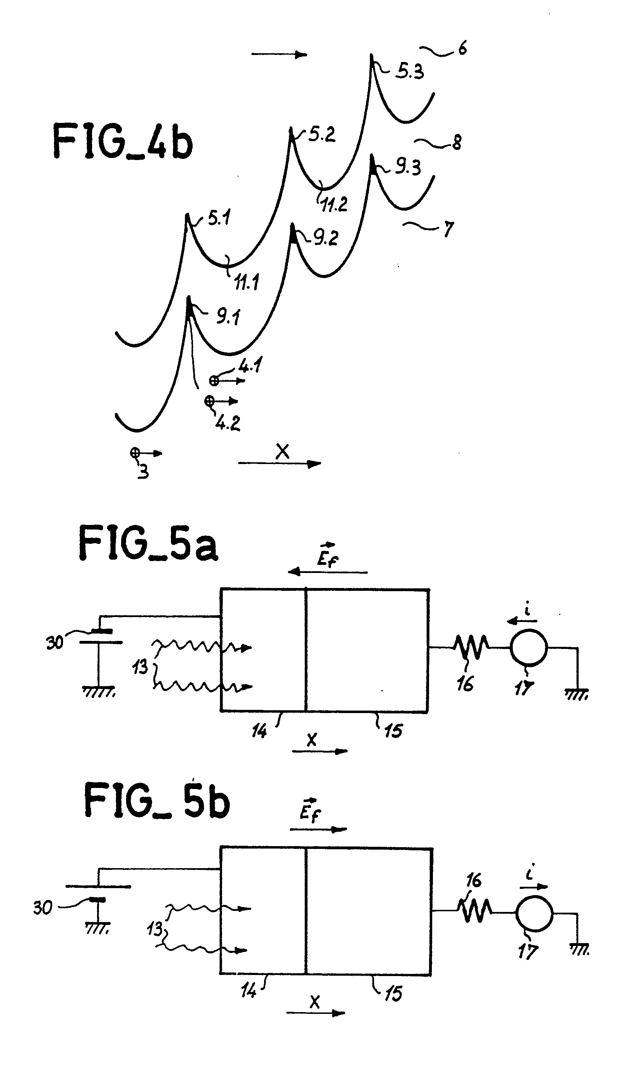

Le fonctionnement d'un DMT est illustré par la figure 4b. La description de cette figure 4b se déduit de celle de la figure 4a en permutant respectivement les expressions :
- "électrons" et "trous" ;
- "puits 5-i de la bande de conduction 6" et "puits 9-i de la bande de valence 7" ;
- "sommet 12-i de la bande de valence 7" par "bas 11-i de la bande de conduction 6" ;
- "bande de valence" et "bande de conduction" ;
De nombreuses applications du DMPC faisant l'objet de l'invention sont envisageables. Dans ce qui suit, on décrit trois applications particulières.

En premier lieu, on peut appliquer ce DMPC aux photodétecteurs à faible bruit. La figure 5a illustre l'application aux photodétecteurs d'un DME. Le problème consiste alors à détecter des photons 13 dans une bande d'énergie donnée. Pour cela, on réalise une jonction entre le DME 15 et un semiconducteur 14 dont la largeur de la bande interdite correspond à l'énergie des photons 13 à détecter. Ce semiconducteur 14 sert à injecter des électrons dans le DME 15. En effet, les photons 13 créent des paires électrons-trous dans le semiconducteur 14. Les électrons sont entraînés dans le DME 15 par le champ de fonctionnement $\vec{E}_f$. A la sortie du DME 15, on détecte un courant électrique i. A titre d'exemple, ce courant i traverse une résistance 16 et est mesuré à l'aide d'un ampèremètre 17. La source de tension permettant d'appliquer le champ $\vec{E}_f$ est notée 30.

La description de la figure 5b, illustrant l'application aux photodétecteurs d'un DMT, se déduit de celle de la figure 5a en permutant respectivement les expressions :
- "DME" et "DMT" ;
- "électrons" et "trous" ;
- et en inversant le sens du champ de fonctionnement $\vec{E}_f$ par rapport à la figure 5a.

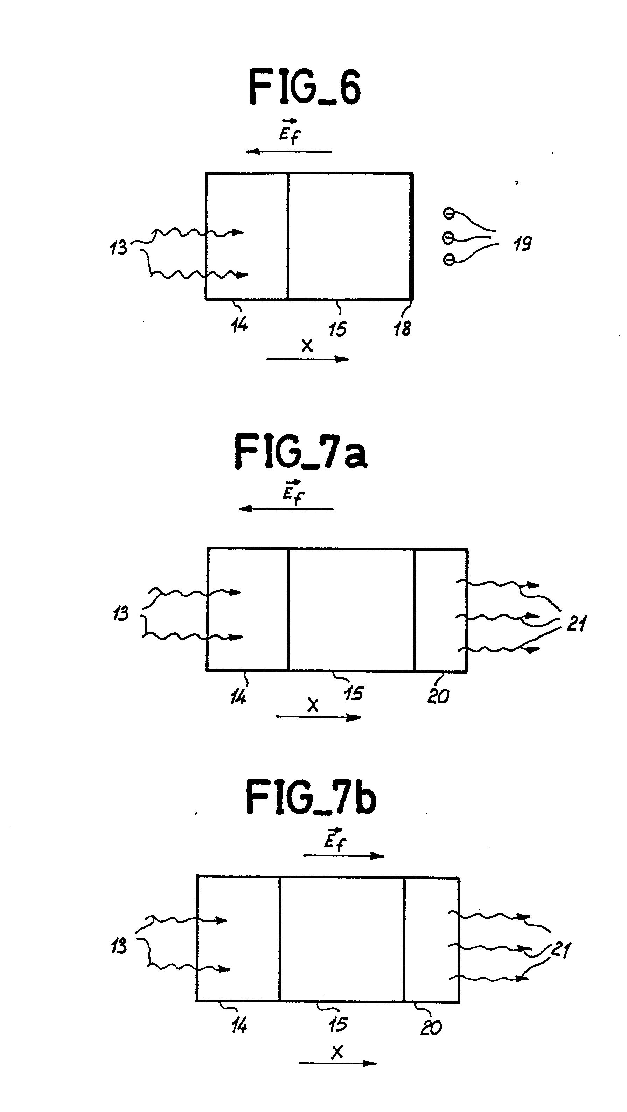

En second lieu, un DME selon l'invention peut être appliqué aux photocathodes à faible bruit, comme le montre la figure 6. Sur cette figure 6, les moyens assurant l'application du champ de fonctionnement $\vec{E}_f$ ne sont pas représentés.

Le problème consiste alors à émettre des électrons libres 19 dans le vide. L'injection d'électrons dans le DME 15 est par exemple obtenue de la manière suivante :

- on réalise une jonction entre le DME 15 et un semiconducteur 14 ;
- on envoie sur ce semiconducteur 14 des photons 13 dont l'énergie correspond à la largeur de la bande interdite du semiconducteur 14 ;
- les photons 13 créent alors dans le semiconducteur 14 des paires électrons-trous ;
- les électrons sont entraînés dans le DME 15 par le champ électrique de fonctionnement $\vec{E}_f$ ; l'électrode positive nécessaire pour appliquer ce champ, située juste avant la surface 18, est conçue de manière à être la plus transparente possible pour les électrons ; à titre d'exemple, elle est constituée :

- d'un dépôt métallique uniforme très mince (quelques dizaines d'angströms) ;
- d'un grillage métallique mince ;
- d'une zone de semiconducteur très dopée p.

Les électrons multipliés par le DME 15 sont ensuite éjectés dans le vide grâce à un traitement préalable de la surface 18 du matériau constituant le DME 15, par exemple en faisant sur cette surface un dépôt d'oxygène ou de césium.

En troisième lieu le DMPC, objet de l'invention, peut être appliqué à un convertisseur-amplificateur de photons infrarouges en photons visibles, autrement dit à un visionneur infrarouge. La figure 7a illustre l'application aux visionneurs infrarouges d'un DME. Le problème consiste alors à transformer peu de photons infrarouges 13 en de nombreux photons visibles 21. L'injection d'électrons dans le DME 15 est obtenue de la même manière que précédemment (on choisit évidemment un semiconducteur 14 ayant une bande interdite dont la largeur correspond à l'énergie de photons infrarouges). Les électrons multipliés par le DME 15 sont transformés en photons visibles 21 de la façon suivante :

- on relie la sortie du DME 15 à un matériau semiconducteur 20 fortement dopé p en volume et dont la largeur de la bande interdite correspond à l'énergie de photons visibles ;
- les électrons sortant du DME 15 se recombinent alors avec les trous du semiconducteur 20, en émettant des photons visibles 21.

La description de la figure 7b, illustrant l'application aux visionneurs infrarouges d'un DMT, se déduit de celle de la figure 7a en permutant respectivement les expressions :
- "DME" et "DMT" ;
- "électrons" et "trous" ;
- "dopé p" et "dopé n".

Sur les figures 7a et 7b, les moyens assurant l'application du champ de fonctionnement $\vec{E}_f$ ne sont pas représentés.

Ces trois applications du DMPC 15 ont été exposées à titre d'exemples, non limitatifs.

## Revendications

1. Dispositif de multiplication de porteurs de charge d'un type donné par un phénomène d'avalanche comportant :
- un matériau (1) non conducteur d'électricité ;
- réalisées dans ce matériau (1), des couches (2-1 à 2-3) sensiblement parallèles introduisant des puits de potentiel (5-1 à 5-3) et (9-1 à 9-3) selon une direction (X) sensiblement perpendiculaire auxdites couches (2-i), et constituant des réservoirs où sont confinés des porteurs de charge dudit type ;
- des moyens d'application d'un champ électrique ($\vec{E}_f$), dit champ de fonctionnement, selon la direction (X) sensiblement perpendiculaire auxdites couches ;
- l'injection d'au moins un porteur de charge (3) dudit type, ce porteur (3) étant accéléré par le champ de fonctionnement ($\vec{E}_f$), étant susceptible de produire par un processus de collision ionisante l'éjection d'un porteur de charge (4-2) du même type hors d'un puits de potentiel, les porteurs de charge dudit type étant guidés par le champ de fonctionnement ($\vec{E}_f$), ce mécanisme d'éjection se reproduisant de proche en proche et constituant ainsi un processus de multiplication par avalanche ; caractérisé en ce que :
- le matériau (1) non conducteur d'électricité est un semiconducteur unique de composition homogène ;
- lesdites couches (2-1 à 2-3) sont des zones du semiconducteur dopées n ou p suivant ledit type de porteurs de charge ;
- lesdites couches (2-i) étant séparées par des portions dudit matériau (1) non conducteur d'électricité, les épaisseurs desdites couches (2-i) étant très inférieures aux dimensions, selon la direction (X) sensiblement perpendiculaire aux couches (2-i), desdites portions.

2. Dispositif selon la revendication 1, caractérisé en ce que les couches (2-i) contiennent au plus quelques plans atomiques.

3. Dispositif selon l'une des revendications 1 ou 2, caractérisé en ce que le semiconducteur qu'il comporte est à grande bande interdite, les énergies d'ionisation des porteurs de charge piégés dans les puits de potentiel étant élevées.

4. Dispositif selon l'une des revendications précédentes, caractérisé en ce que la distance entre deux couches (2-i) dopées voisines est telle que l'interaction par effet tunnel entre les puits de potentiel soit négligeable.

5. Dispositif selon l'une des revendications précédentes, caractérisé en ce qu'il comporte des moyens de remplacement des porteurs de charge éjectés hors des puits de potentiel.

6. Dispositif selon l'une des revendications précédentes, caractérisé en ce que :
- les porteurs de charge multipliés sont des électrons ;
- les couches (2-i) sensiblement parallèles réalisées dans le matériau sont des zones dopées n.

7. Dispositif selon la revendication 6, caractérisé en ce que :

- le semiconducteur (1) est dopé p en volume, ($N_a$) notant la concentration volumique en impuretés de type p :

- ce dopage p en volume, le dopage n des couches (2-i), ($N_d$) notant la concentration surfacique en impuretés de type n, et la distance L entre deux couches (2-i) successives sont tels que :

$$N_d > N_a \times L$$

- cette condition assurant sensiblement la désertion en porteurs de charge libres des régions situées entre deux couches (2-i) dopées n voisines, ceci sans vider les réservoirs de trous constitués par les puits de potentiel (5-i) et correspondant physiquement aux couches (2-i).

8. Dispositif selon l'une des revendications 1 à 5, caractérisé en ce que :

- les porteurs de charge multipliés sont des trous ;

- les couches (2-i) sensiblement parallèles réalisées dans le matériau sont des zones dopées p.

9. Dispositif selon la revendication 8, caractérisé en ce que :

- le semiconducteur (1) est dopé n en volume, ($N_d$) notant la concentration volumique en impuretés de type n ;

- ce dopage n en volume, le dopage p des couches (2-i), ($N_a$) notant la concentration surfacique en impuretés de type p, et la distance L entre deux couches (2-i) successives sont tels que :

$$N_a > N_d \times L$$

- cette condition assurant sensiblement la désertion en porteurs de charge libres des régions situées entre deux couches (2-i) dopées p voisines, ceci sans vider les réservoirs d'électrons constitués par les puits de potentiel (9-i) et correspondant physiquement aux couches (2-i).

10. Photodétecteur à faible bruit, caractérisé en ce qu'il comporte :

- un matériau semiconducteur (14) dont la bande interdite est telle que des photons (13) d'énergie donnée puissent être absorbés, créant des paires électrons-trous ;

- un DME (15) selon l'une des revendications 1 à 5 et selon les revendications 6 ou 7, ou bien un DMT (15) selon l'une des revendications 1 à 5 et selon les revendications 8 ou 9 ;

- une jonction entre le semiconducteur (14) et le matériau constituant le DME (15) ou le DMT (15), permettant l'injection d'électrons ou de trous dans ledit DME (15) ou DMT (15) ;

- un système de détection (17) d'un courant électrique (i) sortant du DME (15) ou du DMT (15).

11. Photocathode à faible bruit, caractérisée en ce qu'elle comporte :

- un matériau semiconducteur (14), susceptible d'assurer l'absorption des photons (13) à détecter, et la création de paires électrons-trous ;

- un DME (15) selon l'une des revendications 1 à 5 et selon les revendications 6 ou 7 ;

- une jonction entre le semiconducteur (14) et le matériau constituant le DME (15), permettant l'injection d'électrons dans le DME (15) ;

- une surface (18) susceptible d'assurer l'éjection dans le vide d'électrons libres (19).

12. Visionneur infrarouge, caractérisé en ce qu'il comporte :

- un matériau semiconducteur (14) dont la bande interdite est telle que des photons infrarouges (13) puissent être absorbés, créant des paires électrons-trous ;

- un DME (15) selon l'une des revendications 1 à 5 et selon les revendications 6 ou 7, ou bien un DMT (15) selon l'une des revendications 1 à 5 et selon les revendications 8 ou 9 ;

- une jonction entre le semiconducteur (14) et le matériau constituant le DME (15) ou le DMT (15), permettant l'injection d'électrons ou de trous dans ledit DME (15) ou DMT (15) ;

- un matériau semiconducteur (20) fortement dopé p ou n en volume et dont la largeur de la bande interdite correspond à l'énergie de photons visibles ;

- une jonction entre le dispositif (15) et le semiconducteur (20) ;

- les électrons ou les trous sortant du dispositif (15) se recombinant avec les trous ou les électrons du semiconducteur (20), en émettant ainsi des photons visibles (21).

# FIG_1a

$\overleftarrow{\vec{E}_f}$

4-1

3

4-2

1

2-1    2-2    2-3

$\xrightarrow{\quad}$ X

# FIG_2a

6

$E_F$

8

7

# FIG_2b

6

8

5.1    5.2    5.3

$E_F$

9-1    9-2    9-3

7

$\xrightarrow{\quad}$ X

# FIG_1b

$\vec{E}_f$

FIG_2c

# FIG_3a

6

8

$E_F$

W

# FIG_3b

6

8

$E_F$

W

$\vec{E_f}$

3

# FIG_4a

4.2

4.1

5.1

12.1

9.1

5.2

6

9.2

12.2

5.3

8

9.3

7

x

FIG_4b

FIG_5a

FIG_5b

0 274 940

# FIG_6

$\vec{E}_f$

13

19

14  15  18

X

# FIG_7a

$\vec{E}_f$

13

21

14  X  15  20

# FIG_7b

$\vec{E}_f$

13

21

14  15  20

X

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 023 723  (WESTERN ELECTRIC) <br> * Page 4, ligne 1 - page 13, ligne 16; revendications; figures * <br> --- | 1,3,6-10 | H 01 L  31/10 <br> H 01 L  31/02 <br> H 01 J   1/34 |
| X | FR-A-2 499 317  (WESTERN ELECTRIC) <br> * Page 1, ligne 6 - page 14, ligne 32; revendications; figures * <br> --- | 1-3,6-10 | |
| X | EP-A-0 162 942 <br> (MAX-PLANCK-GESELLSCHAFT ZUR FÖRDERUNG DER WISSENSCHAFT) <br> * Page 9, ligne 11 - page 21, ligne 12; revendications; figures * <br> --- | 1-3,6,7,10 | |
| X | DE-A-2 261 527 <br> (MAX-PLANCK-GESELLSCHAFT ZUR FÖRDERUNG DER WISSENSCHAFTEN) <br> * Page 2, alinéa 3 - page 17, alinéa 2; revendications; figures * <br> --- | 1,2,6,7,10,12 | |
| A | GB-A-1 038 200  (STANDARD TELEPHONES AND CABLES) <br> * Revendications; figure * <br> --- | 1,12 | DOMAINES TECHNIQUES RECHERCHES (Int. Cl.4) |
| A | US-A-4 208 667  (L.L. CHANG) <br> * Revendications; figures * <br> --- | 1,2,12 | H 01 L <br> H 01 J |
| A | US-A-4 053 920  (R.E. ENSTROM) <br> * Colone 1, ligne 60 - colonne 3, ligne 3; revendications; figures * <br> --- | 1,2,11 | |
| P,X | EP-A-0 230 818  (THOMSON-CSF) <br> * Revendications; figures * <br> ----- | 1-3,6-11 | |

Le présent rapport a été établi pour toutes les revendications

| Lieu de la recherche | Date d'achèvement de la recherche | Examinateur |
|---|---|---|
| LA HAYE | 18-03-1988 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P0402)